Europäisches Patentamt

European Patent Office

Office européen des brevets

(19)

(11) **EP 1 102 406 A2**

(12) **EUROPEAN PATENT APPLICATION**

(43) Date of publication:
   **23.05.2001 Bulletin 2001/21**

(51) Int Cl.[7]: **H03M 13/15**

(21) Application number: **00309609.6**

(22) Date of filing: **31.10.2000**

(84) Designated Contracting States:
   **AT BE CH CY DE DK ES FI FR GB GR IE IT LI LU
   MC NL PT SE**
   Designated Extension States:
   **AL LT LV MK RO SI**

(30) Priority: **17.11.1999 US 441859**

(71) Applicant: **STMicroelectronics, Inc.**
   **Carrollton, TX 75006-5039 (US)**

(72) Inventors:
   • **Yang, Honda**
     **Saratoga, CA 95070 (US)**
   • **Gill, John T., III**
     **Stanford, CA 94305 (US)**

(74) Representative: Palmer, Roger et al
   **PAGE, WHITE & FARRER**
   **54 Doughty Street**
   **London WC1N 2LS (GB)**

(54) **Apparatus and method for decoding digital data**

(57)   The present invention relates generally to an improved decoder circuit used for decoding Reed-Solomon or BCH codes. According to one aspect of the invention, a step of performing solving an error locator polynomial is performed concurrently with a step of computing an error pattern. In particular, a decoder is provided which performs concurrent execution of a Chien search that determines the error locator polynomial for a received code word and a Forney algorithm that computes the error pattern.

FIG. 1

EP 1 102 406 A2

**Description**

The present invention relates generally to decoding digital data and, more particularly, to decoding Reed-Solomon codes.

A digital communication system is a system in which information may be transmitted from one entity to another entity. The system may be "digital" in that a communication language used by the system may encode data using symbols from a finite alphabet to represent the information. A transmitting entity may be any source of information. For example, a remote sensing satellite, cellular telephone, computer, or other entity may transmit digital information.

A modulator of the entity modulates information by mapping the information into symbols that can be efficiently transmitted over a communication channel, such as a cable, air, or other communication medium. The modulated information can experience noise signals from external sources, from the medium, or from interference with the modulated information itself. These noise signals may change the modulated information into other forms, which are incorrect or indiscernible by a receiver of the modulated information. The receiver of the modulated information must be able to detect and correct these signals, and request the transmitter to resend the information, if necessary.

Transmission of data in digital form allows for the use of signal processing techniques referred to as error correcting codes (ECCs). Error correction codes are a common solution for detecting and correcting errors in received information. BCH and Reed-Solomon codes, characterized by a finite code including a number of code words that exhibit certain mathematical properties, are commonly used to encode data in digital information systems, including satellite transmission systems, CD-ROMs, computer hard disks, and other systems. Specifically, a Reed-Solomon code is constructed and decoded through the use of finite field arithmetic. Reed-Solomon codes are more fully described in the book entitled <u>Reed Solomon Codes and Their Applications</u>, by Stephen B. Wicker and Vijay Bhargava, IEEE Press, 1994, incorporated by reference in its entirety, and the reader who is unfamiliar with Reed-Solomon codes is requested to refer to tills text for descriptions not reproduced herein. Reed-Solomon codes can be generally described as nonbinary BCH codes, but exhibits properties that are not found in any of the other BCH codes. For example, one of the more significant properties that makes a Reed-Solomon code more useful as a data transmission code is that an (n,k) Reed-Solomon code always has a minimum distance between codes that is exactly equal to (n-k+1). Both Reed-Solomon and BCH codes, their decoding methods, and applications are more fully described in the book entitled <u>Error Control Systems for Digital Communication and Storage</u>, by Stephen B. Wicker, Prentice Hall, Inc. 1995, incorporated by reference in its entirety.

A finite field, GF(q) commonly referred to as a Galois field describes a finite group of q elements which are of the form $p^m$, where p is a prime integer and m is a positive integer. Suppose that a packet of k information symbols, $\{m_0, m_1, ..., m_{k-2}, m_{k-1}\}$, taken from a finite field GF(q). These symbols can be used to construct a polynomial P(x) = $m_0 + m_1 x + ... + m_{k-2} x^{k-2} + m_{k-1} x^{k-1}$. A Reed-Solomon code word c is formed by evaluating P(x) at each of the q elements in the finite field GF(q).

A complete set of code words is constructed by allowing the k information values take on all possible values. Since the information symbols are selected from GF(q), they can each take on q different values. There are thus $q^k$ code words in a Reed-Solomon code. A code is said to be linear if the sum of any two code words is also a code word. It follows from Equation (1) below that Reed-Solomon codes are linear, for the sum of two polynomials of degree k-1 is another polynomial of degree less than or equal to k-1.

$$c = (c_0, c_1, c_2, ..., c_{q-1}) = [P(0), P(\alpha), P(\alpha^2), ..., P(\alpha^{q-1})] \tag{1}$$

The number of information symbols k is called the "dimension" of the code. The term dimension is used because Reed-Solomon code words form a vector space of dimension k over GF(q). Because each code word has q coordinates (see equation (1) above), it is usually said that the code has length n=q. When Reed-Solomon codes (and any other linear codes) are discussed, they are typically denoted by their dimension k as (n,k) codes.

Each Reed-Solomon code word can be related by equation (1) to a system of q linear equations in k variables, as shown in equation (2) below:

$$\begin{aligned}
P(0) &= m_0 \\
P(\alpha) &= m_0 + m_1 \alpha + m_2 \alpha^2 + ... + m_{k-1} \alpha^{k-1} \\
P(\alpha^2) &= m_0 + m_1 \alpha^2 + m_2 \alpha^4 + ... + m_{k-1} \alpha^{2(k-1)} \\
P(\alpha^{q-1}) &= m_0 + m_1 \alpha^{q-1} + m_2 \alpha^{2(q-1)} + ... + m_{k-1} \alpha^{(k-1)(q-1)}
\end{aligned} \tag{2}$$

Any k of these expressions in (2) can be used to construct a system of k equations in k variables. For example, the first k of the above expressions in (2) form the following system.

$$
\begin{bmatrix}
1 & 0 & 0 & \dots & \dots & 0 \\
1 & \alpha & \alpha^2 & \dots & \dots & \alpha^{(k-1)} \\
1 & \alpha^2 & \alpha^4 & \dots & \dots & \alpha^{2(k-1)} \\
. & . & . & \dots & \dots & \\
1 & \alpha^{k-1} & \alpha^{2(k-1)} & \dots & \dots & \alpha^{(k-1)(k-1)}
\end{bmatrix}
\begin{bmatrix}
m_0 \\ m_1 \\ m_2 \\ \dots \\ m_{k-1}
\end{bmatrix}
=
\begin{bmatrix}
P(0) \\ P(\alpha) \\ P(\alpha^2) \\ \dots \\ P(\alpha^{k-1})
\end{bmatrix}
\qquad (3)
$$

This system in (3) can be shown to have a unique solution for the k information symbols {$m_0$, $m_1$,..., $m_{k-2}$, $m_{k-1}$} by computing the determinant of the following coefficient matrix (4).

$$
\begin{bmatrix}
1 & 0 & 0 & \dots & 0 \\
1 & \alpha & \alpha^2 & \dots & \alpha^{(k-1)} \\
1 & \alpha^2 & \alpha^4 & \dots & \alpha^{2(k-1)} \\
\vdots & \vdots & \vdots & \ddots & \vdots \\
1 & \alpha^{k-1} & \alpha^{2(k-1)} & \dots & \alpha^{(k-1)(k-1)}
\end{bmatrix}
\qquad (4)
$$

Using cofactor expansion across the top row of matrix (4), the determinant of this matrix reduces to that of a Vandermonde matrix, and it can be shown that all Vandermonde matrices are nonsingular and thus have one solution. The coefficient matrix for any system formed by the combination of k expressions from equation (2) can be reduced to a Vandermonde matrix form so that any k of the expressions in equation (2) can be used to determine the values of the information coordinates.

As discussed above, a Reed-Solomon code can be used to correct errors. Suppose that t data bits or coordinates of the code word are corrupted by noise during transmission and are received incorrectly. The corresponding expressions in equation (2) are incorrect and would lead to an incorrect solution, if one or more of them were used in the system of equations in (3). A Reed-Solomon code of length q and dimension k can correct up to t errors.

To decode the aforementioned Reed-Solomon codes, an ECC decoder generally performs a step of finding an error locator polynomial which is defined to have as roots the inverses of $\upsilon$ error locators {$X_1$}. The error locator polynomial is found from a set of partial syndromes. A syndrome is defined as a vector that is a function of an error pattern e, and is independent of the transmitted code word **c**. Syndromes may be generated in a decoder for example, by a syndrome generator based on a received sequence of code words. In particular, syndrome values are a vector sum of bits in received parity symbols in a received code word. Computation of syndrome values is well-known in the art. Two well-known techniques for finding the error locator polynomial from a set of partial syndromes are the Berlekamp-Massey and Euclidean algorithms, and these techniques are generally implemented in shift registers.

Given the error locator polynomials, the next step is to find the roots of polynomial equations whose coefficients are from a finite field. These roots provide error location information. The degree of the equation and the number of roots are equal to the number of errors that occur within the received code word. The Chien search algorithm is a systematic means of evaluating the error locator polynomial at successive elements in a field GF($2^m$), thus locating the errors. The Chien algorithm locates errors and the Forney algorithm computes error patterns at each error location.

Modern disk drives use Reed-Solomon ECCs for burst error correction to achieve higher density. On-the-fly, multiple-burst error correction is required to minimize error recovery time and avoid interruption of data flow. The general trend of the Reed-Solomon decoder is to correct more and more symbol errors, where a symbol is typically a byte of data. For example, 9 or 10 bit symbols have been implemented in the industry, but symbols may be any size. Generally, as the number of corrected errors increases, there is a performance decrease in the overall correction process. However, as the trend of disk data rates increases, low latency and cost effective ECC decoders are needed when large number of errors are present.

According to one aspect of the invention, a decoder is provided which has constant decoding latency regardless of the number of symbol errors to be corrected. For example, the decoder takes the same number of clock cycles to correct either I or 100 errors in a worst case. Because of this property, the decoder has a significant performance advantage over conventional decoders when dealing with signals experiencing large numbers of errors. This type of deterministic delay in error correction is particularly important in computer hard disk drive environments where error corrections are desired to be completed within a specified time period. For example, it may be optimal for corrections to be completed within one sector time of a computer hard disk drive. That is, the decoder may perform corrections at the access speed of the hard drive without providing additional delay beyond a time needed to access the disk drive media.

According to one aspect of the invention, an innovative hardware architecture for decoding Reed-Solomon code in hard disk controller (HDC) ASICs is provided which provides a constant latency in correcting errors as the number of symbol errors increases. The process for decoding becomes longer as the number of corrected symbols increases because the error polynomial is conventionally solved before computing an error pattern for the error polynomial. In one aspect of the invention, the step of solving of the error locator polynomial is performed concurrently with the step of computing the error pattern. For example, according to one embodiment of the invention, an apparatus is described which performs concurrent execution of the Chien and Forney Algorithms in a Reed-Solomon decoder.

In one aspect of the invention, a decoder is provided comprising a decoder circuit for-decoding a received code word, the decoder comprising an error locator that receives syndrome information and which generates an error locator polynomial, a solver which solves the error locator polynomial to determine locations of one or more errors in the received code word; and an error pattern computer that computes an error value for a location of the received code word, wherein the error locator polynomial is solved at substantially at the same time the error value is computed. According to one embodiment, the solver solves the error locator polynomial using a Chien search circuit. According to another embodiment of the invention, the error pattern computer computes the error value using the Forney algorithm.

Further features and advantages of the present invention as well as the structure and operation of various embodiments of the present invention are described in detail below with reference to the accompanying drawings. In the drawings, like reference numerals indicate identical or functionally similar elements. Additionally, the left-most one or two digits of a reference numeral identifies the drawing in which the reference numeral first appears.

In the drawings,

Figure 1 is a block diagram of an error correction decoder in accordance with one embodiment of the invention;
Figure 2 is a block diagram of a conventional Chien search circuit;
Figure 3 is a block diagram of a conventional code word verification circuit;
Figure 4 is a block diagram of another conventional Chien search circuit;
Figure 5 is a block diagram of an improved Chien search circuit using shortened codes;
Figure 6 is a block diagram of Chien search circuit searching two roots in parallel;
Figure 7 is a block diagram of a polynomial evaluation circuit;
Figure 8 is a block diagram of a polynomial evaluation circuit;
Figure 9 is a block diagram of a power circuit;
Figure 10 is a block diagram of Forney processor in accordance with one embodiment of the invention;
Figure 11 is a block diagram of an alternative polynomial evaluation circuit;
Figure 12 is a block diagram of an alternate Forney processor in accordance with one embodiment of the invention;
Figure 13 is a block diagram of a single-speed (1X) decoder in accordance with one embodiment of the invention;
Figure 14 is a block diagram of a double-speed (2X) polynomial evaluation circuit in accordance with one embodiment;
Figure 15 is a block diagram of a double-speed (2X) decoder in accordance with one embodiment of the invention;
Figure 16 is a block diagram of a variable-speed polynomial evaluation circuit in accordance with one embodiment; and
Figure 17 is a block diagram of another variable-speed polynomial evaluation circuit in accordance with one embodiment.

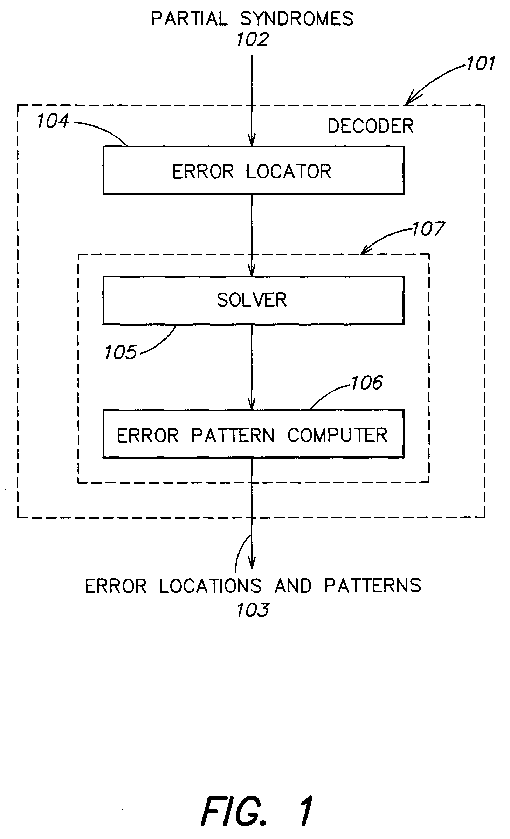

A block diagram of an error correction decoder 101 in accordance with one embodiment of the invention is shown in Figure 1. The decoder 101 processes a set of partial syndromes 102 and generates error locations and error patterns. In other words, its inputs are partial syndromes 102 and outputs are error locations and patterns 103. The decoder may be a part of a communication system that is configured to receive and decode information from one or more data sources. As discussed above, a data source may be any source of information, such as a computer, cellular telephone, or other entity that may transmit digital data.

As shown in Figure 1, the decoder accepts a set of partial syndromes and includes an error locator 104 that finds the error locator polynomial. Two well-known techniques for finding an error locator polynomial from a set of partial syndromes that may be used are the Berlekamp-Massey and Euclidean algorithms. Other techniques may be used.

Given the error locator polynomial, the next step is to find the roots of polynomial equations whose coefficients are from a finite field. These roots provide error location information within a received code word. The degree of the equation and the number of roots are equal to the number of errors that occur in the received code word. Decoder 101 includes a solver 105 that solves the error locator polynomial to determine locations of one or more errors in the received code word. For example, the well-known Chien search algorithm discussed with particularity below may be used to solve the error locator polynomial.

The Chien search algorithm is a systematic means of evaluating the error locator polynomial at successive elements in a field $GF(2^m)$ and may be used to determine error locations in the received code word. Decoder 101 also includes an error pattern computer to determine the magnitude of error at bit locations of the received code word. For example, the well-known Forney algorithm described in more detail below may be used to determine error magnitudes. A decoder in accordance with one embodiment of the invention combines the Chien and Forney algorithms by concurrently finding error locations using the Chien search algorithm and computing error patterns using the Forney algorithm. In particular, the Chien and Forney algorithms may be performed by accumulating terms used to calculate Forney error values within a Chien search circuit.

First, the following is a brief discussion of the Chien and Fomey algorithms and the signals leading up to their application. A t-error correcting BCH code is constructed by first identifying the smallest field $GF(2^m)$ that contains $\alpha$, a primitive $n^{th}$ root of unity. A binary polynomial is then selected so that it has zeroes some 2t consecutive powers of $\alpha$.

$$g(\alpha^b) = g(\alpha^{b+1}) = \cdots = g(\alpha^{b+2t-1}) = 0 \qquad (5)$$

A binary vector $\mathbf{c} = (c_0, c_1, c_2,....,c_{n-1})$ is a code word if and only if its associated polynomial $c(x)=c_0 + c_1x .... c_{n-1} x^{n-1}$ has zeros at these same 2t consecutive powers of $\alpha$. Consider a received polynomial r(x) which can be expressed as the sum of a transmitted code polynomial c(x) (the signal) and an error polynomial $e(x)=e_0+e_1x+...+e_{n-1}x^{n-1}$. A sequence of syndromes is obtained by evaluating the received polynomial at the 2t zeros. To minimize the complexity of the notation, codes discussed are narrow-sense codes (b=1).

$$S_j = r(\alpha^j) = c(\alpha^j) + e(\alpha^j) = e(\alpha^j) = \sum_{k=0}^{n-1} e_k(\alpha^j)^k, \; j = 1,2,...,2t \qquad (6)$$

The computations in (5) are performed in $GF(2^m)$, the field containing the primitive $n^{th}$ root in unity. Assume that the received word has u errors in positions $i_1$, $i_2$, $i_3$,...,$i_\upsilon$ . Because the code is binary, the errors in these positions have the value $e_{ij} = 1$. The syndrome sequence can be expressed in terms of these error locations.

$$S_j = \sum_{l=1}^{\upsilon} e_{il}(\alpha^j)^{il} = \sum_{l=1}^{\upsilon} (\alpha^{il})^j = \sum_{l=1}^{\upsilon} X_l^j, j = 1,...,2t \qquad (7)$$

The $\{X_1\}$ are error locators, for their values indicate the position of the errors in the received code word. Expanding equation (7), we obtain a sequence of 2t algebraic syndrome locations in $\upsilon$ unknown error locations.

$$S_1 = X_1 + X_2 + \cdots + X_\upsilon$$
$$S_2 = X_1^2 + X_2^2 + \cdots + X_\upsilon^2$$
$$S_3 = X_1^3 + X_2^3 + \cdots + X_\upsilon^3 \qquad (8)$$
$$\vdots$$
$$S_{2t} = X_1^{2t} + X_2^{2t} + \cdots + X_\upsilon^{2t}$$

Equations of this form are called power-sum symmetric functions or syndrome digits. Because they form a system of nonlinear algebraic equations in multiple variables, they are difficult to solve in a direct manner. Peterson, a famous mathematician in the field of encoding, showed that BCH syndrome equations can be translated into a series of linear equations which are much easier to solve (Please refer to the journal article entitled Encoding and Error-Correction Procedures for the Bose-Chaudhuri Codes, by W. W. Peterson, IRE Transactions on Information Theory, Vol. IT-6, September 1960, incorporated herein by reference). Let $\Lambda(x)$ be the error locator polynomial that has as its roots the inverses of the $\upsilon$ error locators $\{X_1\}$, The $\Lambda(x)$ polynomial is defined by the following system of linear equations:

$$\Lambda(x) = \prod_{l=1}^{\upsilon}(1 - xX_l) = \Lambda_0 + \Lambda_1 x + \ldots + \Lambda_{\upsilon-1}x^{\upsilon-1} + \Lambda_\upsilon x^\upsilon \qquad (9)$$

An algorithm such as the algorithm by Berlekamp can be used to arrive at more efficient implementation than Peterson's approach, and this algorithm is referred to in the book entitled Algebraic Encoding Theory, by E. R. Berlekamp, McGraw-Hill, 1968, incorporated herein by reference.

The Berlekamp-Massey algorithm allows us to find the error locator polynomial, but there remains the problem of finding the error magnitudes. The following equation (10) relates the known syndrome values to the error locator and error evaluator polynomial:

$$\Lambda(x)\left[1 + S(x)\right] \equiv \Omega(x) \bmod x^{2t+1} \qquad (10)$$

A Berlekamp-Massey algorithm may be used as a more efficient alternative for the correction of large numbers of errors than the Peterson algorithm. Berlekamp's algorithm may be implemented using shift registers (Please see the journal article entitled Shift Register Synthesis and BCH Decoding, by J. L. Massey, IEEE Transactions on Information Theory, Vol. IT-15, No. 1, January 1969, incorporated herein by reference).

Once the error polynomial is known, the roots can be located through the use of a Chien search. A Chien search is more fully described in the journal article entitled Cyclic Decoding Procedure for the Bose-Chaudhuri-Hocquenghem Codes, by R. T. Chien, IEEE Transactions on Information Theory, Vol. IT-10, October 1964, incorporated herein by reference. As discussed above, the Chien search is a systematic means of evaluating the error locator polynomial at all elements in a field $GF(2^m)$.

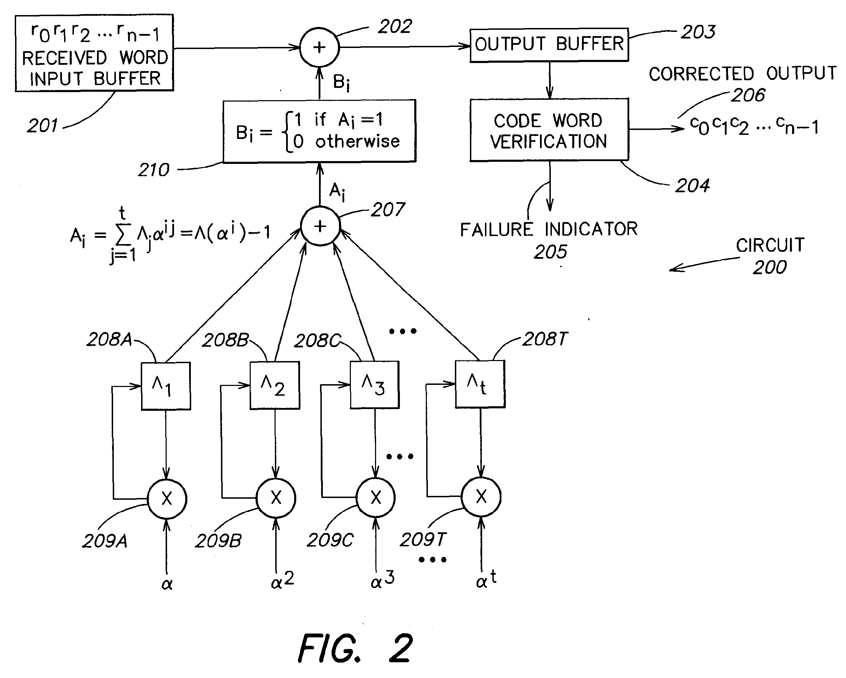

A conventional Chien search circuit is shown in Figure 2. Circuit 200 receives a code word $r_0 \, r_1 \, r_2 \ldots r_{n-1}$ and stores it in an input buffer 201. An error detector/corrector 210 determines whether one or more bits of the received code word are incorrect, and modifies the received code word to correct the incorrect bits. Each coefficient A; of the error locator polynomial is stored in a respective storage location 208 and is repeatedly multiplied by $\alpha^i$ by one or more multipliers 209A-209T, where $\alpha$ is primitive in $GF(2^m)$. Each set of products is then summed by an accumulator 207 to obtain $A_i = \Lambda(\alpha^i)$ - 1. If $\alpha'$ is a root of $\Lambda(x)$, then $A_i = \Lambda(\alpha^i)$ - 1 = 1 and an error is indicated by an error detector 210 at a coordinate of the data code word associated with $\alpha^{-i} = \alpha^{n-i}$. The correction bit $B_i$ is then set to 1 by detector 210 and added to the received bit $r_{n-i}$, of the received data word by accumulator 202. If $A_i \neq 1$, the value of $B_i$ is set to zero by detector 210 and the corresponding received bit is left unchanged. The modified code word is stored in an output buffer 203, where the code word may be used by a receiving system or verified, such as by a code word verification circuit 204. Note that verification may be performed by a code word verification circuit 204 after error correction to ensure that the resulting word is a valid code word. Verification may be performed, for example, by comparing the resulting word with the list of valid code words.

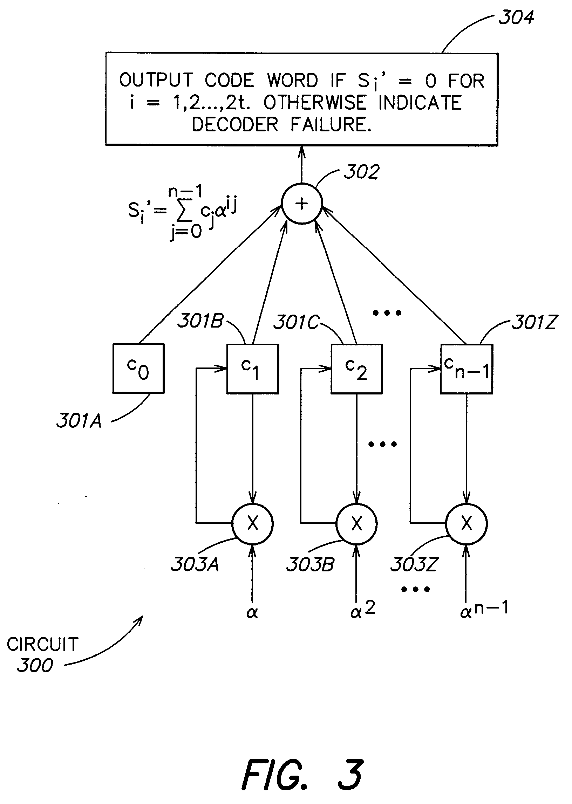

Also, code word verification can be performed by using a circuit 300 similar to that used in the Chien search, as shown in Figure 3. The bits $c_0$, $c_1$, $c_2$,....$c_{n-1}$ of the corrected output word 206 of Figure 2 take the place of the error locator polynomial coefficients in storage locations 301A-301Z. Syndromes $\{S_i\}$ for the corrected word are computed one at a time. If the syndromes of each of the bits of the corrected output word 206 have a value of zero, the corrected word 206 is accepted as a valid code word; otherwise, a decoder failure is indicated by detector 304. In particular, $c_j x_{ij}$ is determined by multiplying (by multipliers 303A-303Z) by the values stored in locations 301A-301Z, respectively, and $c_j x_{ij}$ is accumulated by circuit 302 from j=0 to n-1.

A parallel Chien search circuit may also be used to locate the roots of the error locator polynomial. The following examples use error locator $\Lambda(x)$ polynomials of maximum degree 6, but it should be understood that any error locator polynomial of any degree may be used. The error locator polynomial degree equals the designed error correction power which is modified depending on the application using the error correction code. The amount of storage elements and constant multipliers used to implement the decoder is proportional to the polynomial degree.

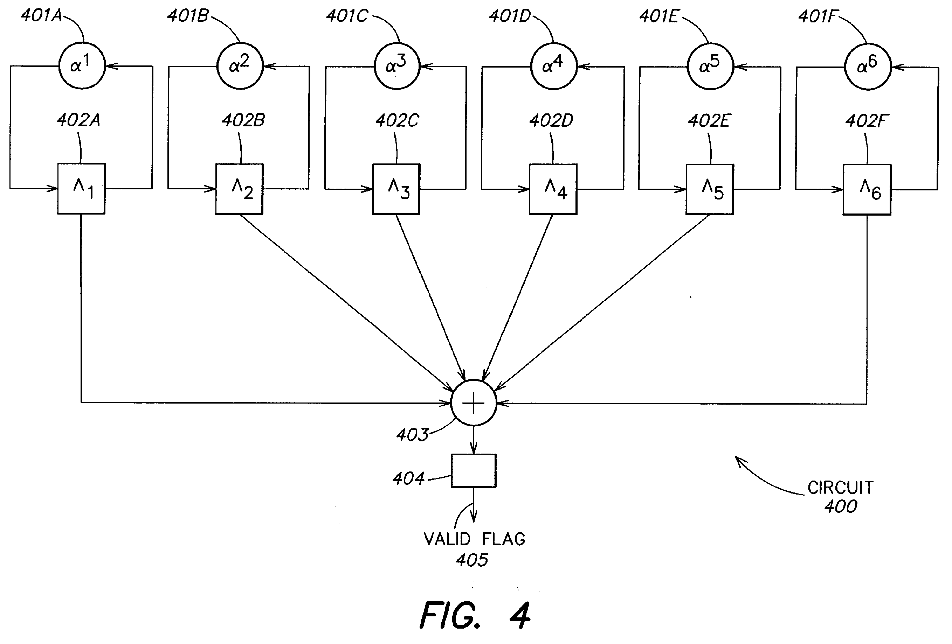

Figure 4 shows another standard Chien search circuit. In Figure 4, a plurality of storage locations 402A-402F are loaded with six polynomial coefficients, $\Lambda_1$ to $\Lambda_6$, respectively. Each coefficient $\Lambda_i$ of the error locator polynomial is repeatedly multiplied by $\alpha^i$ (items 401A-401F) and accumulated by an accumulator 403. If $\alpha^i$ is a root of $\Lambda(x)$, that is $\Lambda(\alpha^i)=0$, then an error is found at the coordinate associated with $\alpha^{-i}$. A VALID flag 405 is raised by detector 404 whenever a root of the error locator polynomial is found, i.e. when the output of accumulator 403 is 1. In general, about $2^m-1$ clock cycles are required if only one coordinate of the received code word is evaluated at a time.

There is improved search latency with shortened Reed-Solomon codes. Specifically, it is not necessary to test for all coordinates when dealing with shortened codes. Reed-Solomon codes, and punctured and shortened-types of Reed-Solomon codes have been adapted for use in conventional data decoders. A Reed-Solomon code is punctured by deleting any of its coordinates, thus these deleted coordinates do not need to be tested. A shortened Reed-Solomon code is created by taking a cross-section of the Reed-Solomon code at an arbitrary coordinate. This is performed by taking all of the code words for which a given coordinate is zero and deleting that coordinate. The resulting collection of vectors is a shortened Reed-Solomon code.

For example, consider encoding information on a hard disk drive having a 512 byte data sector, 3-way interleave configuration and 8-bit error correction code symbols; one third of the error locations do not exist. Hence, only two thirds of a total 255 coordinates need to be tested. Assume that the error locations are within the ranges $\alpha^0$ to $\alpha^{180}$. Recall that the locator polynomial $\Lambda(x)$ has its roots the inverses of the error locators. Therefore, $\Lambda(x)$ is evaluated from $\Lambda(\alpha^{-0})$ to $\Lambda(\alpha^{-180})$ being equal to 0, rather than from $\Lambda(\alpha^0)$ to $\Lambda(\alpha^{180})$.

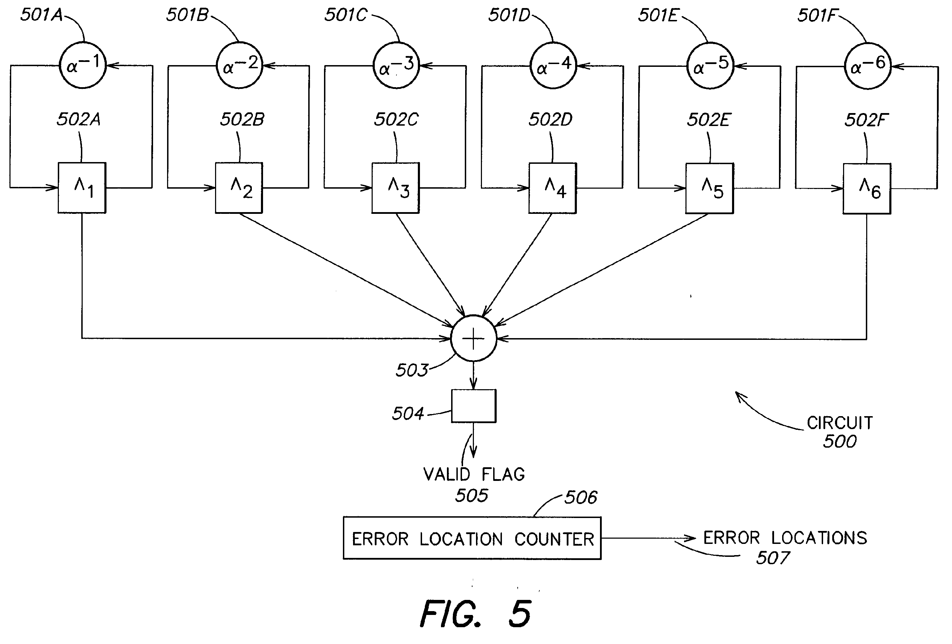

Figure 5 shows another Chien search circuit 500 described in pending U.S. patent application entitled PARALLEL CHIEN SEARCH CIRCUIT by H. Yang, et al., Serial No. 09/141871 filed on August 27, 1998, incorporated herein by reference. Along with the Chien-search circuit 500, an error location counter 506 may be provided which is initialized to zero and incremented on every clock cycle to provide error locations 507. The implementation shown in Figure 5 follows from the above discussions, and includes multiplying each coefficient $\Lambda_i$ stored in storage locations 502A-502F by $\alpha^{-1}$ through $\alpha^{-6}$, respectively (items 501A-501 F). Each coefficient $\Lambda_i$ of the error locator polynomial by $\alpha^{-i}$, instead of $\alpha^i$ as shown in Figure 4 as a result from changing the evaluation of $\Lambda(x)$. The result of the multiplications are accumulated by an accumulator 503, and the result is sent to a detection circuit 504. A VALID flag 505 is raised by detector 504 whenever a root of the error locator polynomial is found.

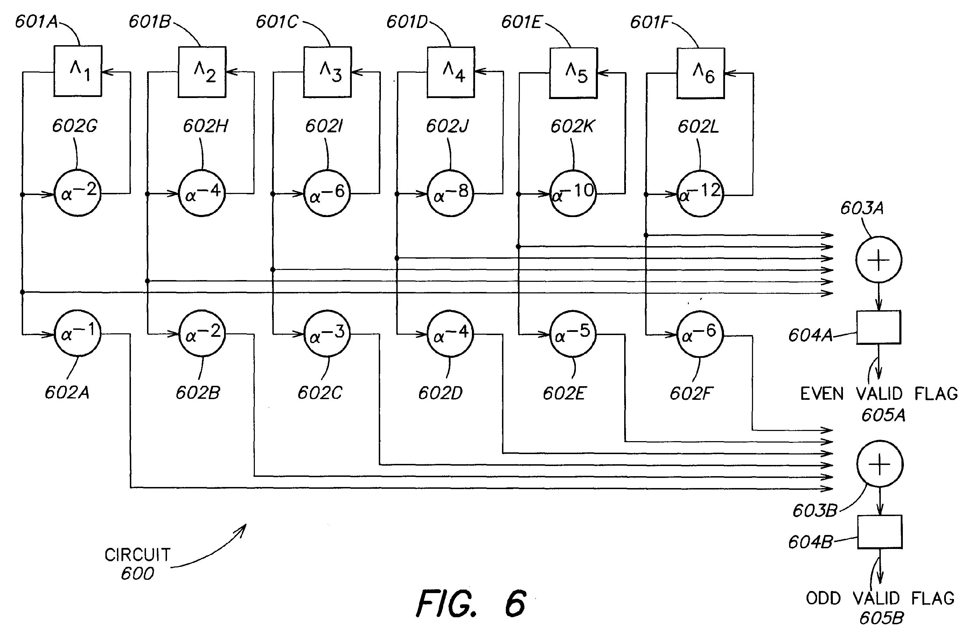

To speed up the search process, a double-speed Chien search circuit 600 may be used such as that shown in Figure 6. In circuit 600, two search circuits may run in parallel. Therefore, search time can be cut in half. In circuit 600, each coefficient $\Lambda_i$ (in Fig. 6, $\Lambda_1$-$\Lambda_6$) is stored in a respective storage location 601A-601F. At each cycle, each coefficient $\Lambda_i$ is multiplied by $\alpha^{-i}$ ($\alpha^{-1}$ through $\alpha^{-6}$ (items 602A through 602F) and accumulated by accumulator 603B, and by $\alpha^{-2i}$ ($\alpha^{-2}$ through $\alpha^{-12}$ (items 602G through 602L)) and accumulated by accumulator 603A. Detector 604A detects, at each test cycle, whether an even bit of the code word is valid. Detector 604B detects, concurrently with the detection performed by detector 604A, whether an odd bit of the code word is valid. Note that storage elements may be shared among two constant multipliers (e.g. items 602B and 602H may be driven from the same storage element 601 B), and two coordinates of the received code word are tested in each test cycle. Examples of parallel Chien search circuits are described in a pending U.S. Patent Application entitled PARALLEL CHIEN SEARCH CIRCUIT by H. Yang, et al., Serial Number 09/141,871 filed on August 27, 1998, incorporated herein by reference.

The Forney algorithm may be used to compute error magnitude at various symbol positions, yielding an error pattern. As discussed-above, a Reed-Solomon code is completely defined by its generator polynomial, whose zeroes are $\alpha^s, \alpha^{s+1},...,\alpha^{s+c-1}$, where $\alpha$ is primitive in $GF(2^m)$. Assume $\upsilon$ errors occurred in locations corresponding to indexes 1, 2,..., $\upsilon$. Hence the error location number for position $l$ is defined to be $X_1$. The error value $Y_1$ given by Forney algorithm is

$$Y_1 = X_1^{(1-s)}\frac{\Omega(X_l^{-1})}{\Lambda^1(X_l^{-1})} \tag{11}$$

where $\Omega(X_1^{-1})$ is the error evaluator polynomial $\Omega(x)$ evaluated at $x = X_1^{-1}$ and $\Lambda'(X_1^{-1})$ is the formal derivative $\Lambda'(x)$ of the error locator polynomial $\Lambda(x)$ evaluated at $x = X_1^{-1}$. $\Omega(x)$ and $\Lambda'(x)$ polynomials are expressed below:

$$\Omega(x)=\Omega_0 + \Omega_1 x + \Omega_2 x^2 +... \tag{12}$$

$$\Lambda'(x) = \Lambda_l + \Lambda_3 x^2 + \Lambda_5 x^4 + ... \tag{13}$$

As discussed above, according to one aspect of the invention, a decoder circuit is provided that performs the Forney algorithm concurrently with a Chien search. In particular, an aspect of the invention includes the realization that components of the Forney algorithm may be implemented using a Chien style search circuit. As mentioned above, the Chien search algorithm is a systematic means of evaluating the error locator polynomial at all elements in a field $GF(2^m)$. Each coefficient $\Lambda_i$ of the error locator polynomial $\Lambda(x)$ for $i > 0$ is repeatedly multiplied by $\alpha^i$. Each set of products is then summed and compared with 1. If the summation is 1, then $\alpha^{-i}$ is a root of $\Lambda(x)$.

The same concept can be applied to Fomey algorithm in that the values of $\Lambda'(X_1^{-1})$, $\Omega(X_1^{-1})$, and $X_1^{(1-s)}$ can be computed in the same manner as performing the Chien search. This is possible because the Chien search circuit finds the error locations in sequential manner. Instead of evaluating $\Lambda'(x)$ and $\Omega(x)$ at $x = X_1^{-1}$, and computing $X_1^{(1-s)}$ after $X_1$ is found by the Chien search circuit, $\Lambda'(X_1^{-1})$ can be accumulated from $\Lambda'(\alpha^0)$, $\Lambda'(\alpha^{-1})$, $\Lambda'(\alpha^{-2})$, etc. Also, $\Omega(X_1^{-1})$ can be accumulated from $\Omega(\alpha^0)$, $\Omega(\alpha^{-1})$, $\Omega(\alpha^{-2})$, etc. Further, $X_1^{(1-s)}$ can be accumulated from $(\alpha^0)^{1-s}$, $(\alpha^1)^{1-s}$, $(\alpha^2)^{1-s}$, etc. Thus, $Y_1$ may be accumulated concurrently with the sequential steps of the Chien search.

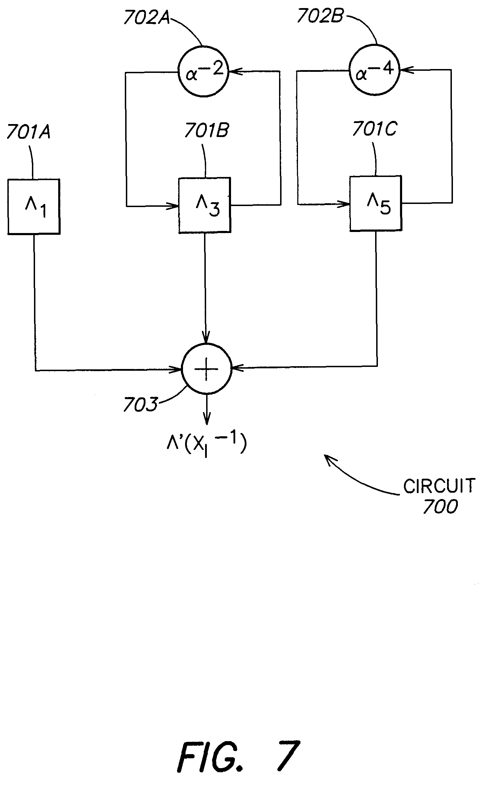

For the examples above where the $\Lambda(x)$ polynomial has maximum degree 6, the maximum degree of the $\Lambda'(x)$ polynomial is 5 (3 nonzero coefficients) and of the $\Omega(x)$ polynomials is 5. The hardware circuitry for evaluating $\Lambda'(X_1^{-1})$, $\Omega(X_1^{-1})$, and $X_1^{(1-s)}$ are shown in Figures 7, 8, and 9, respectively, and are discussed further below.

The storage elements in circuit 700 of Figure 7 are initialized by three coefficients of the $\Lambda(x)$ locator polynomial -- $\Lambda_1$, $\Lambda_3$, and $\Lambda_5$ (items 701A, 701B, and 701C, respectively). In successive cycles, storage element 701A remains the same value. The other two storage elements 701B and 701C are updated by their current contents multiplied by $\alpha^{-2}$ (item 702A) and $\alpha^{-4}$ (item 702B), respectively. Values of the three storage elements are accumulated by an accumulator 703 at each processing cycle.

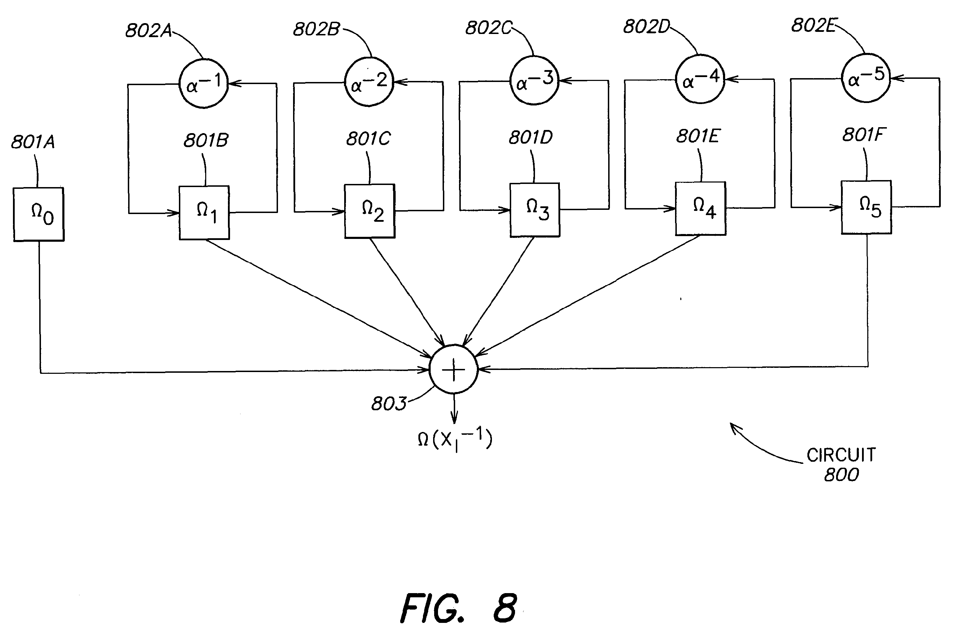

The storage elements 801 A through 801F shown in Figure 8 are initialized by the coefficients of $\Omega(x)$ polynomial -- $\Omega_0$ to $\Omega_5$, respectively. In successive cycles, the value stored in storage element 801 A remains the same. The other five storage elements 801B-801F are updated by their current contents multiplied by $\alpha^{-1}$ to $\alpha^{-5}$ at blocks 802A-802E, respectively. The values of storage elements 801A through 80 IF are accumulated by an accumulator 803 at each processing cycle.

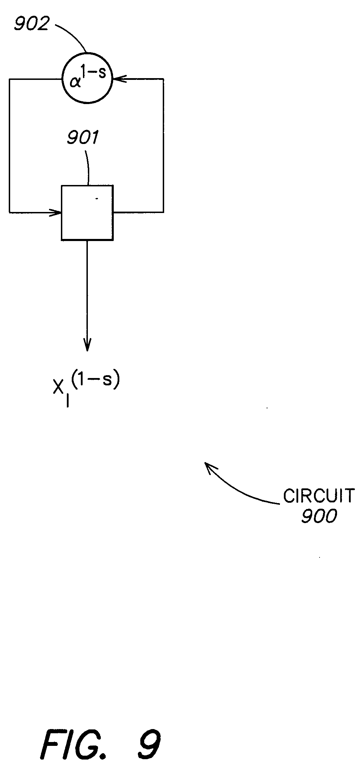

The storage element 901 shown in Figure 9 is initialized by $\alpha^0$. In successive cycles, storage element 901 is overwritten by its current contents multiplied by $\alpha^{1-s}$ at block 902.

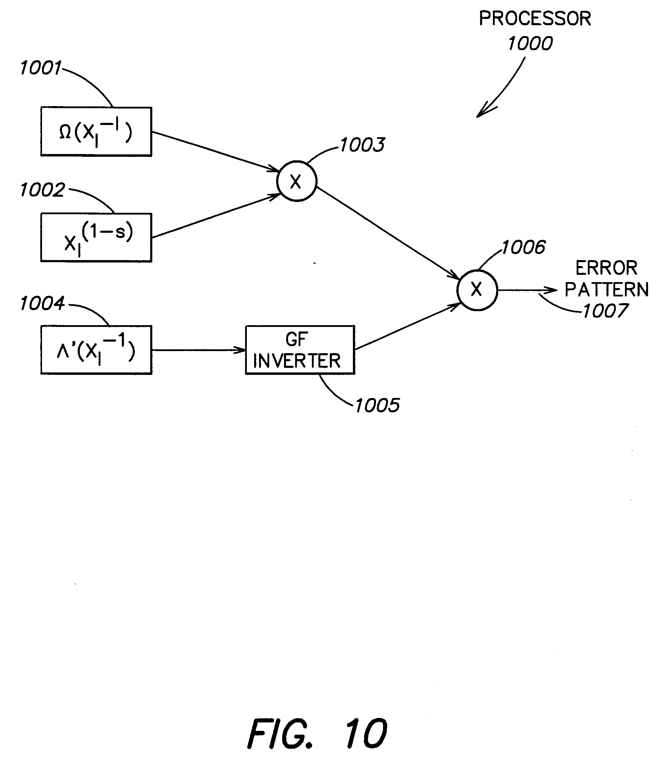

By taking the circuits 700, 800, and 900 shown in Figures 7-9, one can construct a Forney processor 1000 shown in Figure 10 which is configured to execute the following Forney formula:

$$Y_1 = X_1^{(1-s)} \frac{\Omega(X_1^{-1})}{\Lambda(X_1^{-1})} \qquad (14)$$

On a first clock cycle, the Forney processor shown in Figure 10 effectively computes an error pattern 1007 for $X_1 = \alpha^0$. On the second clock cycle, the processor computes an error pattern 1007 for $X_1 = \alpha^1$, etc. These error patterns 1007 for a particular received symbol are used if the Chien search has found an error in the corresponding location of the received code word.

Processor 1000 shown in Figure 10 includes a circuit 1001 that computes $\Omega(X_1^{-1})$ and a circuit 1002 that computes $X_1^{(1-s)}$ such that the values of $\Omega(X_1^{-1})$ and $X_1^{(1-s)}$ may be multiplied by multiplier 1003. $\Lambda'(X_1^{-1})$ may be computed by a circuit 1004 and may be inverted by a Galois Field inverter 1005 as discussed above, the result of which may be multiplied by the result of the multiplication above by multiplier 1006.

In one aspect of the invention, the $X_1^{(1-s)}$ term is premultiplied by $\Omega(X_1^{-1})$ in the Forney equation (14). That is, it is possible to combine the $X_1^{(1-s)}$ term and the $\Omega(x)$ polynomial in the Forney equation as shown in Equation (15) below:

$$X_I^{(1-s)} \cdot \Omega(X_I^{(-1)}) = X_I^{(1-s)} \cdot (\Omega_0 + \Omega_1 X_I^{-1} + \Omega_2 X_I^{-2} + \Omega_3 X_I^{-3} + \ldots)$$
$$= \Omega_0 X_I^{(-s+1)} + \Omega_1 X_I^{(-s)} + \Omega_2 X_I^{(-s-1)} + \Omega_3 X_I^{(-s-2)} + \ldots \qquad (15)$$

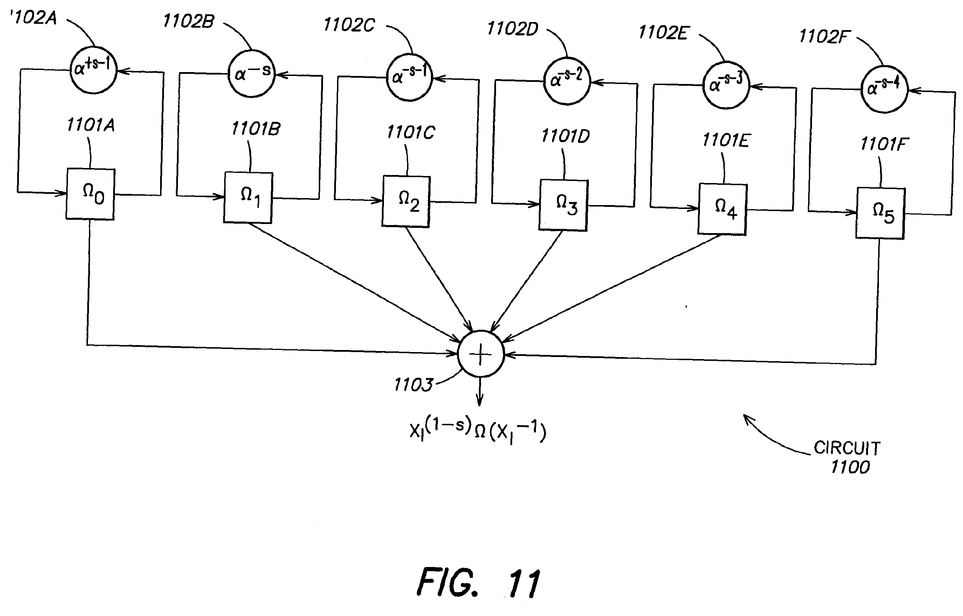

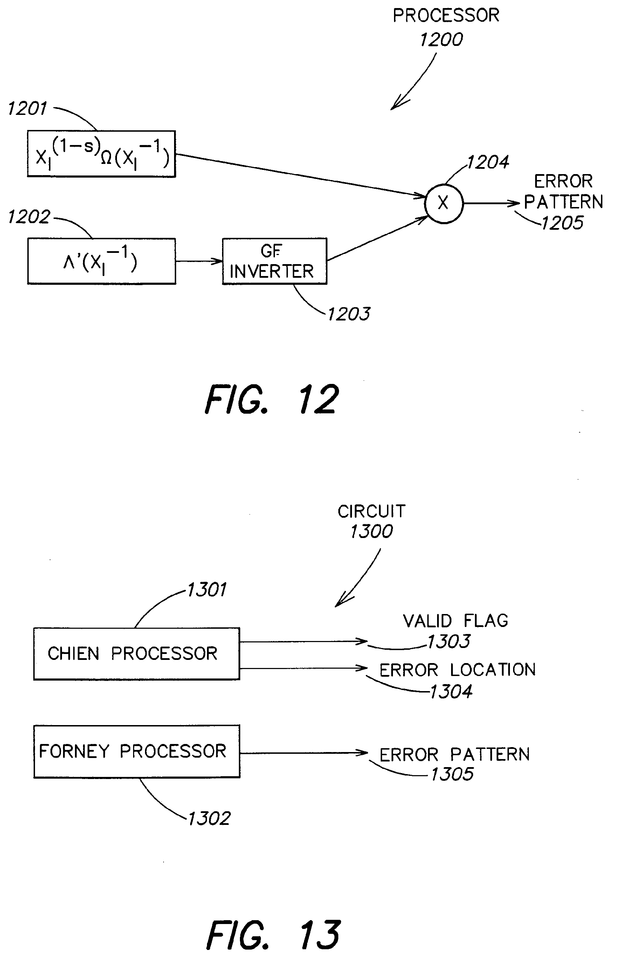

The $\Omega(x)$ polynomial evaluation circuit 800 shown in Figure 8 can be changed according to above equation (15) producing circuit 1100 shown in Figure 11. Circuit 1100 includes storage locations 1101A-1101F initialized with the values of $\Omega_0 - \Omega_5$, respectively. One advantage of premultiplying $X_1^{(1-s)}$ term in the Forney equation (14) is to eliminate one Galois field multiplier in Figure 10. The new Forney processor 1200 corresponding to the described change to circuit 800 in Figure 8 is shown in Figure 12. Processor 1200 includes a circuit 1201 that computes $X_1^{(1-s)}\Omega(X_1^{-1})$ and a circuit 1202 that computes $\Lambda'(X_1^{-1})$.

$\Lambda'(X_1^{-1})$ may be inverted by a Galois Field inverter 1203 as discussed above, the result of which may be multiplied by the output of circuit 1201 by multiplier 1204. The result of the multiplication by multiplier 1204 is the error pattern 1205 of the received bit of the code word produced sequentially at each evaluation cycle.

Note that in Figure 11 the powers of constant multipliers 1102A-1102F have been changed from -1,-2, ...,-5 in Figure 8 to (-s+1), (-s), (-s-1) (-s-4). The hardware cost of these two different sets of constant multipliers may vary depending on selection of variable s. Because the selection of variable s completely defines the generator polynomial of Reed-Solomon codes, the technique of premultiplying $X_1^{(1-s)}$ term may in fact save logic gates in implementing the decoder circuit. Likewise, it is also possible to combine $X_1^{(1-s)}$term and the $\Lambda'(x)$ polynomial. For some choices of s, combining with $\Lambda'(x)$ may result in using less gates in the implemented circuit. The determination of gate savings is implementation-specific.

Figure 13 shows an example decoder circuit 1300 that may be used to execute the Chien and Forney algorithms concurrently. For example, the Chien search circuit from Figure 5 may be used, that is, circuit 1301 may be a single speed Chien search engine. Alternatively, other Chien search circuits may be used. Further, the Forney processor 1200 in Figure 12 may be used as Forney processor 1302. Because calculations performed by circuits 1301 and 1302 are performed sequentially, it is beneficial to perform them substantially at the same time to reduce the delay of serializing the two separate sequential operations. It should be understood that steps need not be performed exactly concurrently such that a reduction of delay is observed.

On every evaluation cycle, the Chien 1301 and Forney 1302 processors provide a potential error location 1304 and pattern 1305. An evaluation cycle may be, for example, a clock cycle of circuit 1300. The VALID flag 1303 provided by the Chien search circuit serves the purpose of qualifying those error locations 1304 and patterns 1305. In particular, when the VALID flag 1303 is asserted in any given cycle, a corresponding error location 1304 and pattern 1305 are then used to correct the detected errors. Otherwise, those potential error locations and patterns not specified by the outputs of the Chien processor 1301 are ignored at other times.

The worst-case decoding latency for the circuit 1300 shown in Figure 13 is approximately $2^m$ - 1 clock cycles, wherein the valid Reed-Solomon symbols are defined in GF($2^m$ ), without taking the shortened codewords into consideration. Note that the worst case latency of the circuit 1300 is independent of the number of errors to be corrected by the Chien search circuit. As mentioned above with respect to Figure 5, the number of clock cycles can be further reduced for shortened Reed-Solomon codes because some coordinates of the received code word are not used. Because the Forney processor may be implemented using a Chien style search circuit, the entire decoder also has an upper bounded decoding latency regardless of the number of errors to be corrected. Therefore, the decoder circuit 1300 may be referred to as a "constant latency decoder."

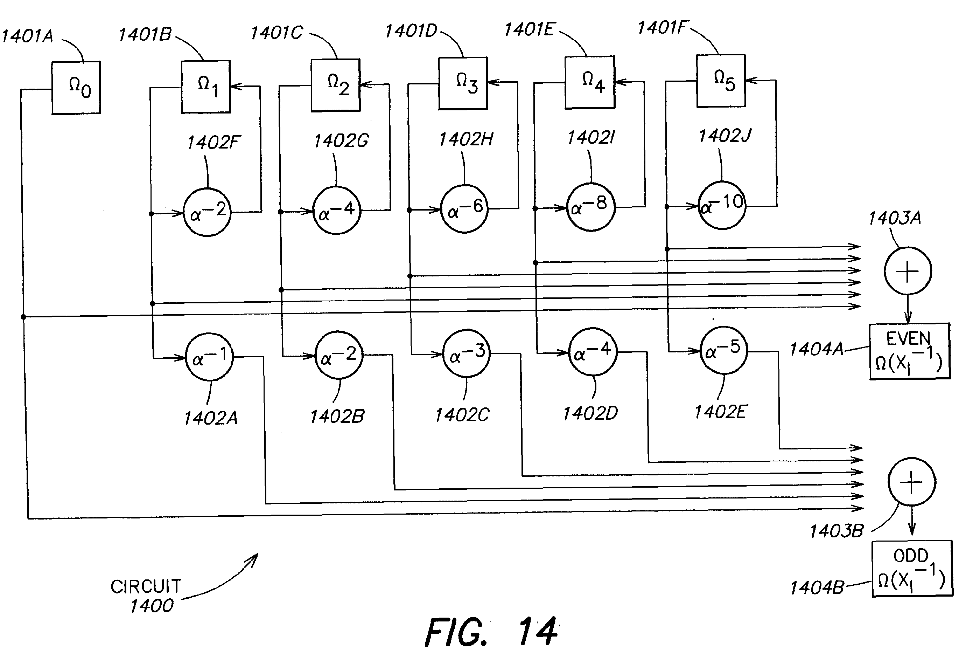

When it is desirable to further reduce decoding latency, a double-speed Chien search circuit 600 described above with respect to Figure 6 can be implemented for the Forney algorithm. For example, the $\Omega(x)$ polynomial evaluation circuit 800 in Figure 8 can be replaced by the circuit 1400 shown in Figure 14. Increases in speed are produced because each coefficient is multiplied by higher powers of $\alpha$ on every clock cycle compared with the single speed circuit 800 shown in Figure 8 which uses successive powers of $\alpha$. For example, the storage element labeled $\Omega_1$ (item 801B) is updated by its current contents multiplied by $\alpha^{-1}$ on every clock cycle in Figure 8 while the storage element labeled $\Omega_1$ (item 1401B) is multiplied and updated by $\alpha^{-2}$ in Figure 14. An upper summation produced by accumulator 1403A shown in Figure 14 corresponds to all even symbol error locations, i.e. $\alpha^0$, $\alpha^2$, ..., etc. while a lower summation produced by accumulator 1403B is produced for all odd symbol error locations, i.e. $\alpha^1$, $\alpha^3$, ...,etc.

Circuit 1400 includes storage elements 1401A through 140 IF initialized by coefficients of the $\Omega(x)$ polynomial -- $\Omega_0$ to $\Omega_5$, respectively. In successive cycles, the value stored in storage element 1401A remains the same as the initialized value $\Omega_0$. The other five storage elements 1401B-1401F are updated by their current contents multiplied by $\alpha^{-2}$, $\alpha^{-4}$,...,$\alpha^{-10}$ at blocks 1402F-1402J, respectively. The values of storage elements 1401 A through 1401 F are accumulated by an accumulator 1403A at each processing cycle. Also, the values of the five storage elements 1401B-1401F are multiplied by $\alpha^{-1}$,$\alpha^{-2}$,...,$\alpha^{-5}$ at blocks 1402A-1402E, respectively. The results of these multiplications are summed by accumulator 1403B.

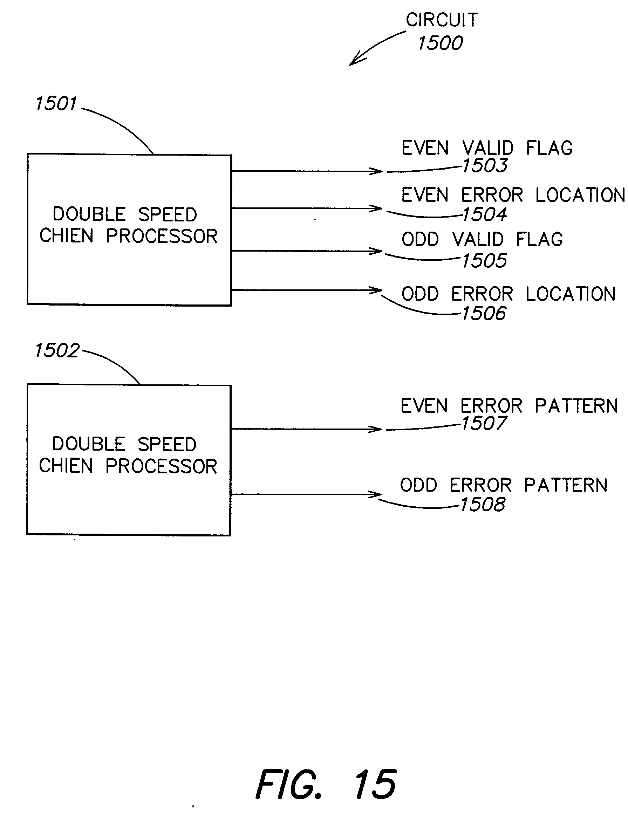

The $\Lambda'(x)$ polynomial evaluation circuit shown in Figure 7 and $X_1^{(1-s)}$ power circuit shown in Figure 9 may also be modified in the same manner. The end result is that Forney processor can compute two potential error patterns in one clock cycle. The modified $\Lambda'(x)$ polynomial evaluation circuit may be combined with a modified $X_1^{(1-s)}$ power circuit and with the double-speed Chien search circuit shown in Figure 6 to produce a double-speed decoder as shown in Figure 15.

At each evaluation cycle, the double-speed Chien processor 1501 and double-speed Forney processor 1502 provide both even and odd error location and error pattern information. More specifically, the double-speed Chien processor 1501 produces an even error location output 1504, an odd error location output 1506, and their corresponding VALID flags 1503 and 1505, respectively. Also, double-speed Forney processor 1502 produces an even 1507 and odd 1508 error pattern information. Information 1503-1508 may be subsequently used by a correction circuit to correct one or two errors of the received code word at each evaluation cycle.

It can be readily seen that the basic single-speed circuit architecture shown in Figure 13 is scalable to higher speeds. If a triple-speed (3X) decoder is required, all the building blocks in the decoder will include three times as many Galois field constant multipliers as a single-speed (1X) decoder. However, the number of storage elements in the 3X decoder remains the same. Therefore, a *nX* decoder has a *l/n* decoding latency at the expense of *n* times as many constant multipliers.

Given the small number of errors the decoder is designed to correct compared with the overall codeword length, the Chien search circuit may not find errors most of the time. In the case of the double-speed decoder design shown in Figure 15, the double-speed Forney processor computes two error patterns in one clock cycle, although, in practical application, the error patterns are almost always ignored. From these observations, it follows that a variable stepping Forney processor may be implemented which computes appropriate error patterns given the instruction from the Chien search circuit. Thus, the Forney processor can run at full speed as the Chien search circuit in most cases, and the Forney processor slows down only when specific roots are found. The processor slows down due to finding roots accounts for only a small fraction of the total decoding latency.

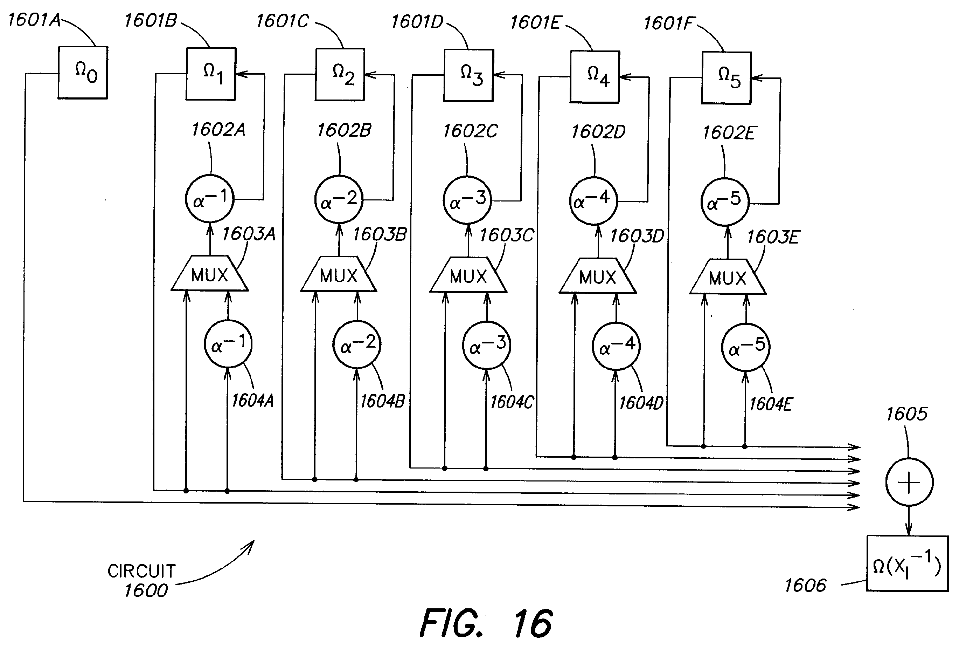

Figure 16 shows one embodiment of a variable-speed polynomial evaluation circuit 1600, such as a Fomey processor, in accordance with one embodiment of the invention. Circuit 1600 includes a number of storage elements 1601A-1601F initialized by coefficients of the $\Omega(x)$ polynomial-- $\Omega_0$ to $\Omega_5$, respectively. In successive cycles, the value stored in storage element 1601A remains the same as the initialized value $\Omega_0$. The five other storage elements 1601B-1601F are updated by their current contents multiplied by values depending on the configuration of multiplexers 1603A-1603E.

In Figure 16, multiplexers 1603A-1603E are controlled by a VALID flag provided from the Chien search circuit. For a double-speed (2X) Chien search circuit, the odd VALID flag is used to control the multiplexers. Whenever the odd VALID flag is not asserted, the storage elements 1601B-1601F, initialized with $\Omega_1$ to $\Omega_5$, are updated by their current contents multiplied by $\alpha^{-2}$(equivalently first multiplied by $\alpha^{-1}$ and then multiplied by $\alpha^{-1}$ again) to $\alpha^{-10}$ (equivalently first multiplied by $\alpha^{-5}$ and then multiplied by $\alpha^{-5}$ again), respectively. In other words, the Forney processor 1600 advances at the same speed as the Chien search circuit with which it is associated. On the other hand, when the odd VALID flag is asserted, the storage elements, labeled from $\Omega_1$ to $\Omega_5$ , are first updated by their current contents multiplied by $\alpha^{-1}$ to $\alpha^{-5}$ in one cycle. On the next cycle, they are updated by their contents multiplied by $\alpha^{-1}$ to $\alpha^{-5}$ again. In other words, the Forney processor 1600 does two single stepping cycles as supposed to one double stepping cycle. Note that the Forney processor 1600 takes one extra clock cycle to catch up with the Chien search circuit. This may not be a disadvantage compared with the original double speed circuit presented in Figure 14 if only one symbol can be corrected in the data buffer at a time. In that case, the decoder associated with circuit 1600 is paused and therefore loses one cycle if two roots are found simultaneously.

One benefit of this design is the elimination of one summation circuit of XOR trees. Note that there are two summation circuits in Figure 14, labeled even and odd. There is only one summation circuit shown in Figure 16. The difference in hardware cost between circuits become significant with large polynomial degrees or even higher-speed decoder design. For example, a 3X Chien search engine can work with a variable-speed Forney processor to produce a high-performance decoder.

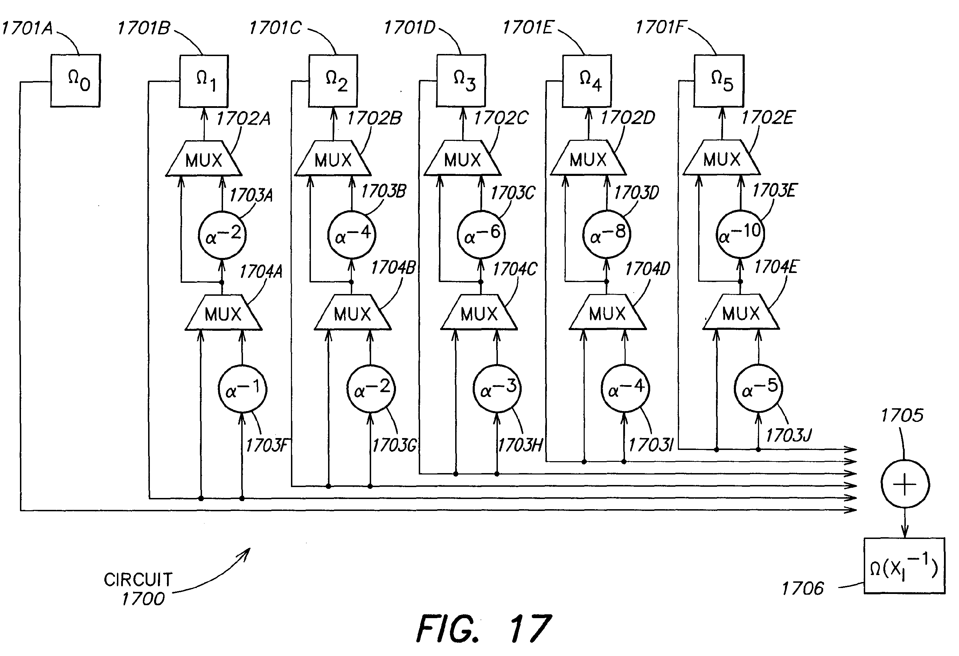

Figure 17 shows another variable-speed polynomial evaluation circuit 1700 in accordance with another embodiment of the invention, such as a Fomey processor. The evaluation circuit 1700 shown in Figure 17 can perform single, double, or triple stepping cycles as required, depending on where errors are found by a 3X Chien search circuit. In this case, only one summation circuit 1705 is needed as compared with three summation circuits used in the implementation described above. Also note that there are only two banks of constant multipliers as opposed to three in a standard triple-speed $\Omega(x)$ polynomial evaluation circuit at the expense of more control logic for selecting multiplexers.

In particular, circuit 1700 includes a number of storage elements 1701A-1701F initialized by coefficients of the $\Omega(x)$ polynomial -- $\Omega_0$ to $\Omega_5$, respectively. In successive cycles, the value stored in storage element 1701A remains the same as the initialized value $\Omega_0$. The five other storage elements 1701B-1701F are updated by their current contents multiplied by values depending on the configuration of multiplexers 1702A-1702E and 1704A-1704E. In Figure 17, multiplexers 1702A-1702E and 1704A-1704E are controlled by a VALID flag provided by a Chien search circuit with which circuit 1700 is associated.

Another potential benefit is to replace higher powers of constant multipliers by lower power alternatives. This is achieved by chaining lower powers of constant multipliers together. For example, ten constant multipliers shown in Figure 14 range from $\alpha^{-1}$ to $\alpha^{-10}$ while they are from $\alpha^{-1}$ to $\alpha^{-5}$ in Figure 16. Practically, lower powers of constant multipliers tend to be cheaper and smaller, and, in practicality, this will help offset the additional cost of multiplexers.

While various embodiments of the present invention have been described above, it should be understood that they have been presented by way of example only, and not limitation. For example, the decoder and methods may be adapted for any number of speeds or length of code words. Thus, the breadth and scope of the present invention are not limited by any of the above exemplary embodiments, but are defined only in accordance with the following claims and their equivalents.

**Claims**

1. A decoder circuit for decoding a received code word, the decoder comprising:

   an error locator that receives syndrome information and which generates an error locator polynomial;
   a solver which solves the error locator polynomial to determine locations of one or more errors in the received code word; and
   an error pattern computer that computes an error value for a location of the received code word, wherein the error locator polynomial is solved at substantially at the same time the error value is computed.

2. The decoder circuit according to claim 1, wherein the solver solves the error locator polynomial using a Chien search circuit.

3. The decoder circuit according to claim 1, wherein the error pattern computer computes the error value using the Forney algorithm.

4. The decoder circuit according to claim 1, wherein the error locator generates the error locator polynomial using a Berlekamp-Massey algorithm.

5. The decoder circuit according to claim 1, wherein the error locator generates the error locator polynomial using a Euclidean algorithm.

6. The decoder circuit according to claim 1, wherein the solver includes a circuit having:

   a plurality of storage elements, each of which is initialized with a coefficient value of the error locator polynomial;
   a plurality of multipliers, each of which is associated with a respective storage element, wherein each multiplier is configured to perform a multiplication by multiplying a primitive root by a value stored in the respective storage element; and
   an accumulator for accumulating a result of the multiplication.

7. The decoder circuit according to claim 1, wherein the solver generates at least one signal that controls a speed of operation of the error pattern computer.

8. The decoder circuit according to claim 6, wherein the solver includes two or more circuits operating in parallel.

9. The decoder circuit according to claim 1, wherein the error pattern computer includes a circuit having:

   a plurality of storage elements, each of which is initialized with a coefficient value of an error evaluator polynomial;
   a plurality of multipliers, each of which is associated with a respective storage element, wherein each multiplier is configured to perform a multiplication by multiplying a primitive root by a value stored in the respective storage element; and
   an accumulator for accumulating a result of the multiplication.

10. , The decoder circuit according to claim 9, wherein the error pattern computer includes two or more circuits operating in parallel.

PARTIAL SYNDROMES
*102*

*101*

DECODER

*104*

ERROR LOCATOR

*107*

SOLVER

*105*

*106*

ERROR PATTERN COMPUTER

ERROR LOCATIONS AND PATTERNS
*103*

# FIG. 1

FIG. 2

EP 1 102 406 A2

OUTPUT CODE WORD IF $S_i' = 0$ FOR $i = 1,2...,2t$. OTHERWISE INDICATE DECODER FAILURE.

*304*

*302*

$$S_i' = \sum_{j=0}^{n-1} c_j \alpha^{ij}$$

*301B* *301C* $\cdots$ *301Z*

$c_0$ | $c_1$ | $c_2$ | $c_{n-1}$

*301A*

$\cdots$

×  ×  ×

*303A*  *303B*  *303Z*

$\cdots$

$\alpha$  $\alpha^2$  $\alpha^{n-1}$

CIRCUIT
*300*

# FIG. 3

FIG. 4

EP 1 102 406 A2

FIG. 5

FIG. 6

EP 1 102 406 A2

702A

702B

$\alpha^{-2}$

$\alpha^{-4}$

701A

701B

701C

$\wedge_1$

$\wedge_3$

$\wedge_5$

$\bigoplus$

703

$\wedge'(X_I{}^{-1})$

CIRCUIT
700

FIG. 7

CIRCUIT
800

$\Omega(X_i^{-1})$

FIG. 8

902

$\alpha^{1-s}$

901

$X_i^{(1-s)}$

CIRCUIT
900

FIG. 9

PROCESSOR
*1000*

*1001*

$$\Omega(X_I^{-I})$$

*1003*

$$X_I^{(1-s)}$$

*1002*

X

*1006*

ERROR
PATTERN
*1007*

X

*1004*

$$\Lambda'(X_I^{-1})$$

GF
INVERTER

*1005*

# FIG. 10

FIG. 11

EP 1 102 406 A2

PROCESSOR
*1200*

*1201*

$$X_I^{(1-s)}\Omega(X_I^{-1})$$

*1202*

$$\wedge'(X_I^{-1})$$

GF INVERTER

*1203*

*1204*

X

ERROR PATTERN
*1205*

FIG. 12

CIRCUIT
*1300*

*1301*

CHIEN PROCESSOR

VALID FLAG
*1303*

ERROR LOCATION
*1304*

FORNEY PROCESSOR

ERROR PATTERN
*1305*

*1302*

FIG. 13

CIRCUIT
1400

FIG. 14

CIRCUIT
*1500*

*1501*

DOUBLE SPEED
CHIEN PROCESSOR

→ EVEN VALID FLAG
*1503*

→ EVEN ERROR LOCATION
*1504*

→ ODD VALID FLAG
*1505*

→ ODD ERROR LOCATION
*1506*

*1502*

DOUBLE SPEED
CHIEN PROCESSOR

→ EVEN ERROR PATTERN
*1507*

→ ODD ERROR PATTERN
*1508*

# FIG. 15

FIG. 16

$$\text{FIG. } 17$$

**FIG. 17**